# EUROPÄISCHE PATENTANMELDUNG

(11) **EP 4 644 917 A1**
(43) Veröffentlichungstag der Anmeldung: **05.11.2025**
(21) Anmeldenummer: 24172984.7
(22) Anmeldetag: 29.04.2024
(51) Int. Cl.: G01R 27/18, G01R 31/52, H01R 24/30

(54) **VORRICHTUNG ZUM ELEKTRISCHEN VERBINDEN EINES ELEKTRISCHEN VERBRAUCHERS MIT EINER ELEKTROINSTALLATION**

(71) Anmelder: Safetytest GmbH, 96114 Hirschaid Bayern (DE)
(72) Erfinder: Schulze, Simon, 96114 Hirschaid (DE)
(74) Vertreter: Zeitler Volpert Kandlbinder Patentanwälte Partnerschaft mbB

(57) **Zusammenfassung**

Die Erfindung betrifft eine Vorrichtung 200 zum elektrischen Verbinden eines elektrischen Verbrauchers mit einer Elektroinstallationsanlage, insbesondere einer stationären Elektroinstallationsanlage eines Gebäudes oder einer ortsveränderlichen Elektroinstallationsanlage, beispielsweise einer ortsveränderlichen elektrischen Stromversorgung, wie beispielsweise eines mobilen Stromerzeugungsaggregates, zum bestimmungsgemäßen Betrieb des elektrischen Verbrauchers. Hierbei weist die Vorrichtung mindestens eine Prüfeinrichtung 16 auf, die für eine Elektroprüfung von sicherheitsrelevanten, elektrischen Eigenschaften des elektrischen Verbrauchers ausgebildet ist

## Beschreibung

Die Erfindung betrifft eine Vorrichtung zum elektrischen Verbinden eines elektrischen Verbrauchers mit einer Elektroinstallationsanlage, insbesondere einer stationären Elektroinstallationsanlage eines Gebäudes oder einer ortsveränderlichen Elektroinstallationsanlage, beispielsweise einer ortsveränderlichen elektrischen Stromversorgung, wie beispielsweise eines mobilen Stromerzeugungsaggregates, zum bestimmungsgemäßen Betrieb des elektrischen Verbrauchers, gemäß dem Oberbegriff des Patentanspruchs 1.

Es sind Mehrfachsteckdosen oder Verlängerungskabel bekannt, um einen elektrischen Verbraucher mit einer Elektroinstallationsanlage, beispielsweise in einem Gebäude, elektrisch zu verbinden, um den elektrischen Verbraucher bestimmungsgemäß in Betrieb zu nehmen. Hierbei dient eine Mehrfachsteckdose dazu, mehrere elektrische Verbraucher an einer einzelnen Wandsteckdose der Elektroinstallationsanlage bestimmungsgemäß zu betreiben. Ein Verlängerungskabel dient dazu, eine Distanz zwischen einer Wandsteckdose der Elektroinstallationsanlage und dem Standort des elektrischen Verbrauchers zu überbrücken, wenn ein Netzkabel des elektrischen Verbrauchers kürzer ist als die Distanz zwischen einer Wandsteckdose und dem elektrischen Verbraucher.

Derartige Vorrichtungen zum Verbinden des elektrischen Verbrauchers mit der Elektroinstallationsanlage haben lediglich die Funktion, eine Versorgungsenergie für den elektrischen Verbraucher in Form von elektrischem Strom zu übertragen.

Weiterhin sind Fehlerlichtbogen-Schutzeinrichtung (sogenannte AFDD-Schalter; umgangssprachlich auch Brandschutzschalter oder Kontaktfehlerschalter) bekannt (vgl. https://de.wikipedia.org/wiki/Fehlerlichtbogen-Schutzeinrichtung). Fehlerlichtbogen-Schutzschalter analysieren Strom- und Spannungsverlauf mittels digitaler Signalverarbeitung und unterbrechen den Stromkreis bei Signaturen, die typisch für Schwellichtbögen sind. Sie verhindern damit Überhitzungen an schlechten Kontaktstellen oder bei Überschlägen zwischen zwei Leitern und können dadurch etwa die Hälfte aller Brände verhindern, die durch Elektroinstallationen und -geräte hervorgerufen werden. Daraus leitet sich auch die umgangssprachliche Bezeichnung Brandschutzschalter ab. Derartige Schalter werden in Schaltkästen von Elektroinstallationsanlage verbaut.

Der Erfindung liegt die Aufgabe zugrunde, eine Vorrichtung der o.g. Art hinsichtlich deren Funktionsumfanges zu verbessern.

Diese Aufgabe wird erfindungsgemäß durch eine Vorrichtung der o.g. Art mit den in Anspruch 1 gekennzeichneten Merkmalen gelöst. Vorteilhafte Ausgestaltungen der Erfindung sind in den weiteren Ansprüchen beschrieben.

Dazu ist es bei einer Vorrichtung der o.g. Art erfindungsgemäß vorgesehen, dass die Vorrichtung mindestens eine Prüfeinrichtung aufweist, die für eine Elektroprüfung von sicherheitsrelevanten, elektrischen Eigenschaften des elektrischen Verbrauchers ausgebildet ist.

Dies hat den Vorteil, dass eine Funktionsfähigkeit von Schutzmaßnahmen gegen unerwünschte gesundheitliche Gefährdungen einer den elektrischen Verbraucher bedienenden Person während des laufenden, bestimmungsgemäßen Betriebs des elektrischen Verbrauchers geprüft und überwacht werden können, ohne dass ein bestimmungsgemäßer Betrieb des elektrischen Verbrauchers für derartige Elektroprüfungen unterbrochen werden muss. Zusätzlich können auftretende Fehler sofort und unabhängig von etwaigen Prüfintervallen erkannt werden, wodurch die Sicherheit des Betriebes von elektrischen Verbrauchern signifikant erhöht wird.

Einen besonders hohen Sicherheitsstandard während des bestimmungsgemäßen Betriebs des elektrischen Verbrauchers erzielt man dadurch, dass die Prüfeinrichtung Mittel zur Elektroprüfung des elektrischen Verbrauchers für folgende elektrische Eigenschaften und Schutzeinrichtungen beinhaltet, eine Schutzleiterprüfung, eine Prüfung des Isolationswiderstandes bei elektrischen Verbrauchern mit berührbaren, elektrisch leitfähigen Bauteilen, eine Prüfung des Isolationswiderstandes bei elektrischen Verbrauchern ohne berührbare, elektrisch leitfähige Bauteile, eine Berührstrbmmessung und/oder eine Schutzleiterstrom- bzw. Differenzstrommessung.

Eine kontinuierliche Prüfung bestimmter elektrischer Eigenschaften und/oder Schutzeinrichtungen des elektrischen Verbrauchers erzielt man dadurch, dass die Prüfeinrichtung eine Prüfsonde aufweist, die derart ausgebildet ist, dass diese mit mindestens einem Bauteil des elektrischen Verbrauchers lösbar oder unlösbar verbindbar ist.

Ein Sicherstellen von der Funktionsfähigkeit von Schutzmaßnahmen gegen unerwünschte gesundheitliche Gefährdungen von Person während des laufenden, bestimmungsgemäßen Betriebs eines elektrischen Verbrauchers an einer Elektroinstallationsanlage erzielt man dadurch, dass die mindestens eine Prüfeinrichtung für eine Elektroprüfung von sicherheitsrelevanten, elektrischen Eigenschaften der Elektroinstallationsanlage ausgebildet ist.

Einen besonders hohen Sicherheitsstandard während des bestimmungsgemäßen Betriebs des elektrischen Verbrauchers an einer jeweiligen Elektroinstallationsanlage erzielt man dadurch, dass die Prüfeinrichtung Mittel zur Elektroprüfung der Elektroinstallationsanlage für folgende elektrische Eigenschaften und Schutzeinrichtungen beinhaltet, Prüfen einer Fehlerstrom-Schutzeinrichtung (RCD), Prüfen und Bestimmen eines Auslösestromes für die RCD, Prüfen und Bestimmen einer Auslösezeit für die RCD, Prüfen eines Leitungsschutzschalters (LS), Prüfen und Bestimmen eines ohmschen Widerstandes eines Schutzleiters, Prüfen und Bestimmen einer Frequenz eines von der Elektroinstallationsanlage gelieferten Wechselstromes, Prüfen und Bestimmen einer Phase eines von der Elektroinstallationsanlage gelieferten Wechselstromes, Prüfen und Bestimmen einer Schleifenimpedanz L-N-PE RCD, Prüfen und Bestimmen einer Schleifenimpedanz L-N-PE und/oder Prüfen und Bestimmen einer Netzimpedanz L-N.

Eine besonders einfach anzuwendende Vorrichtung, die auch von Person ohne spezielle elektrotechnische Fachkenntnisse, wie diejenigen einer Elektrofachkraft, verwendet werden kann, erzielt man dadurch, dass die Vorrichtung ein Elektro-Verlängerungskabel, eine Elektro-Mehrfachsteckdose oder eine Steckergehäuse ist.

Ein besonders breites Anwendungsspektrum der erfindungsgemäßen Vorrichtung erzielt man dadurch, dass die Vorrichtung für eine Elektroinstallationsanlage mit folgenden elektrischen Eigenschaften ausgebildet ist, Netzspannung 0 V bis 300 V Wechselstrom mit 40 Hz bis 60 Hz und Stromstärken bis 16 A.

Eine zusätzliche Ermittlung einer potenziellen Brandgefahr durch die Bildung von an sich unerwünschten Lichtbögen bzw. Fehlerlichtbögen bzw. Schwellichtbögen erzielt man dadurch, dass die Prüfeinrichtung Mittel zum Detektieren von Fehlerlichtbögen bzw. Schwellichtbögen aufweist. Hierbei erfolgt die Ermittlung von Fehlerlichtbögen besonders funktionssicher dadurch, dass die Mittel zum Detektieren von Fehlerlichtbögen zum Auswerten eines zeitlichen Differenzstrom-Verlaufes und/oder eines oberwelligen Verbraucherstromes im Zeitbereich und/oder im Frequenzbereich derart ausgebildet sind, dass aus dem zeitlichen Differenzstrom-Verlauf und/oder aus dem oberwelligen Verbraucherstrom, insbesondere mittel Kl, auf einen Fehlerlichtbogen geschlossen wird.

Die Erfindung wird im Folgenden anhand der Zeichnung näher erläutert. Diese zeigt in
- Fig. 1: eine erste bevorzugte Ausführungsform einer erfindungsgemäßen Vorrichtung in einer perspektivischen Darstellung und
- Fig. 2: eine zweite bevorzugte Ausführungsform einer erfindungsgemäßen Vorrichtung in einer perspektivischen Darstellung.

Nachfolgend wird die Erfindung anhand von bevorzugten Ausführungsformen erläutert, wobei funktionsgleiche Teile mit identischen Bezugszeichen bezeichnet sind.

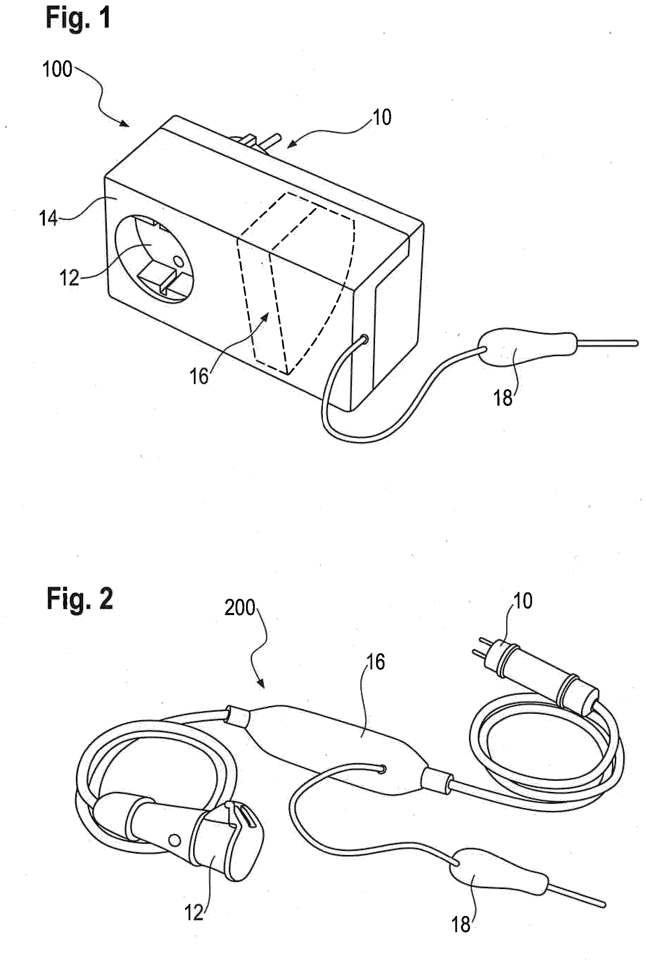

Die in Figur 1 dargestellte, erste bevorzugte Ausführungsform einer erfindungsgemäßen Vorrichtung ist als Steckergehäuse 100 ausgebildet. Dieses Steckergehäuse 100 weist einen Stecker 10, beispielsweise in Form eines Schuko-Steckers, und eine Steckdose 12, beispielsweise in Form einer Schuko-Steckdose, auf. Der Stecker 10 dient zum Einstecken in eine Steckdose (nicht dargestellt) einer nicht dargestellten Elektroinstallationsanlage, beispielsweise in einem Gebäude. Dort sind derartige Steckdosen üblicherweise in den Gebäudewänden vorgesehen. Diese Steckdosen von Elektroinstallationsanlagen in Gebäuden dienen zur elektrischen Energieversorgung von elektrischen Verbrauchern, deren Netzkabel mit einem freien Ende und einem entsprechend dort angeordneten Stecker in die Steckdose der Elektroinstallationsanlage eingesteckt werden. Daraufhin kann der elektrische Verbraucher mit elektrischer Energie versorgt und bestimmungsgemäß betrieben werden.

Die erfindungsgemäße Vorrichtung dient nun dazu, elektrisch zwischen einer Anschluss-Steckdose der Elektroinstallationsanlage des Gebäudes und dem elektrischen Verbraucher geschaltet zu werden. Hierzu wird der Stecker 10 des Steckergehäuses 100 in die Anschluss-Steckdose der Elektroinstallationsanlage eingesteckt. Die nunmehr noch freie Steckdose 12 des Gehäuses 100 dient zum Einstecken des Steckers des Netzkabels des elektrischen Verbrauchers. Auf diese Weise ist das Steckergehäuse 100 mit darin befindlichen elektrischen Schaltungen elektrisch zwischen die Elektroinstallationsanlage und den elektrischen Verbraucher geschaltet.

Erfindungsgemäß ist in einem Gehäuse 14 des Steckergehäuses 100 eine Prüfeinrichtung 16 vorgesehen, die elektrisch einerseits über den Stecker 10 mit der Elektroinstallationsanlage und andererseits über die Steckdose 12 mit dem elektrischen Verbraucher verbunden ist. Diese Prüfeinrichtung ist derart ausgebildet, dass sie verschiedene elektrische Prüfungen hinsichtlich von elektrischen Eigenschaften und Schutzmaßnahmen an dem elektrischen Verbraucher durchführen kann. Weiterhin ist vorgesehen, dass die Prüfeinrichtung derart ausgebildet ist, dass sie verschiedene elektrischen Prüfungen hinsichtlich von elektrischen Eigenschaften und Schutzmaßnahmen der Elektroinstallationsanlage durchführen kann. Die Ergebnisse und gegebenenfalls Messdaten dieser elektrischen Prüfung werden dann beispielsweise über eine drahtlose Datenverbindung an ein externes Gerät übertragen, welches die Ergebnisse und Messdaten archiviert und gegebenenfalls für eine gedruckte Dokumentation vorbereitet. Neben der Archivierung ist es optional alternativ oder zusätzlich vorgesehen, dass die Messergebnisse auch Alarme auslösen, wenn sich der Sicherheitszustand der Elektroinstallationsanlage und/oder des angeschlossenen Verbrauchers verschlechtert. Hierzu werden die Messdaten beispielsweise in eine Cloud hochgeladen und dort mit entsprechenden mathematischen Methoden und Algorithmen ausgewertet. In Abhängigkeit von den Ergebnissen dieser mathematischen Methoden und Algorithmen werden dann weitere Aktionen ausgelöst, wie beispielsweise ein Alarm oder eine Mitteilung, dass eine Wartung der Elektroinstallationsanlage und/oder des angeschlossenen Verbrauchers erforderlich ist. Ggf. trennt dann die Prüfeinrichtung 16 automatischen die Verbindung zwischen Verbraucher und Elektroinstallationsanlage. Optional zusätzlich kann auch gleich eine Anforderung bzw. Bestellung für erforderliche Ersatzteile ausgelöst und/oder ein Wartungs- bzw. Reparaturtermin reserviert werden.

In einer zweiten bevorzugten Ausführungsformen, wie in Figur 2 dargestellt, ist die erfindungsgemäße Vorrichtung als Verlängerungsleitung 200 ausgebildet. In diese Verlängerungsleitung ist die Prüfeinrichtung 16 eingeschleift. Die Verlängerungsleitung kann wie jede andere elektrische Verlängerungsleitung verwendet werden, d.h. für deren Anwendung sind keine elektrotechnischen Fachkenntnisse erforderlich. Auch hier kann über einen separaten Anschluss eine Prüfsonde 18 vorgesehen sein.

Hinsichtlich des elektrischen Verbrauchers sind folgende Elektroprüfungen vorgesehen:

### Schutzleiterprüfung:

Falls an dem elektrischen Verbraucher ein Schutzleiter vorhanden ist, wird dieser geprüft. Hierzu ist eine separate Sondenleitung mit einer Prüfsonde 18 vorgesehen, die elektrisch mit der Prüfeinrichtung 16 verbunden ist. Die Prüfsonde wird mit dem Schutzleitersystem des elektrischen Verbrauchers elektrisch verbunden und es wird die Schleifenimpedanz über das Gehäuse des elektrischen Verbrauchers gemessen. Für den elektrischen Verbraucher gelten Grenzwerte abhängig von Querschnitt und Leitungslänge bis zur Anschluss-Steckdose der Elektroinstallationsanlage von 0,0X Ohm bis 1 Ohm.

### Prüfen/Messen von Isolationswiderständen:

Isolatiosnwiderstände werden geprüft und bestimmt. Bei elektrischen Verbrauchern ohne berührbar leitfähige Teile, welche nicht mit dem PE verbunden sind, wird die Isolation mit über 500V DC von LN zu PE gemessen. Bei elektrischen Verbrauchern der Schutzklasse II (SKII - berührbar leitfähige Teile, welche nicht mit dem PE verbunden sind) wird mittels der Prüfsonde 18 auch mit der Sonde and diesen Teilen gegen LN gemessen. Die Isolationsmessung kann entfallen, wenn man eine Differenzstromüberwachung einsetzt.

### Prüfen/Messung des Berührstromes.

Hier wird im Betrieb mit der Prüfsonde 18 der Berührstrom der SKII Teile gemessen. Bei Isolationsmessung können derartige Fehler nicht auftreten, da das Gerät nicht im Betrieb ist. Diese Messung ist dann möglich, wenn eine händische Führung der Prüfsonde 18 erfolgt.

### Prüfen/Messen des Schutzleiterstromes (Differenzstrom):

Es erfolgt eine Messung im Betrieb also aktiv. Dies macht eine separate Isolationsmessung und ggf. eine Ersatzableitstrommessung entbehrlich. Diese sind nur passiv möglich, also bei abgeschaltetem Gerät (keine Netzspannung). Eine direkte Methode erfordert das isolierte aufstellen des Prüflings, was jedoch nicht praxistauglich ist. Mit der vorliegenden Erfindung kann der Differenzstrom aktiv überwacht werden. Dies führt zu einer Verbesserung der Sicherheitsbewertung des Betriebs, da auch Trends erkannt werden können welche eventuell nur zeitlich begrenzt auftreten oder nur bei bestimmten Funktionen des elektrischen Verbrauchers auftreten oder auftreten, wenn sich ein Gerätezustand verschlechtert.

Hinsichtlich der Elektroinstallationsanlage sind folgende Elektroprüfungen vorgesehen:

### Fehlerstrom-Schutzeinrichtung, kurz RCD:

Normativ wird die Auslösezeit gemessen. In der Praxis wird meist noch der Auslösestrom gemessen, um Vorbelastungen in der Anlage oder weitere Faktoren feststellen zu können

### Leitungsschutzschalter kurz LS:

Zum Nachweis der Schutzmaßnahme werden die Leitungsimpedanzen nachgewiesen, so dass der Schutzschalter beim Kurzschluss/Fehlerfall auslösen kann. Aus der gemessenen Impedanz lässt sich der Kurzschlussstrom errechnen, welcher dann mit der Charakteristik des Schalters in Form eines Grenzwerts verglichen wird.

### Der Schutzleiter:

Der Widerstand des Schutzleiters wird mit mind. 200mA nachgewiesen, dafür gilt der Grenzwert 1 Ohm, welcher jedoch von der Fachkraft bewertet werden muss, ob dieser zu den gegebenen Leitungslängen bis zum Verteiler stimmig ist. Herkömmlich erfolgt eine Messung mit 200 mA über eine lange Leitung vom Verteiler bis zur Steckdose und über diese die Ermittlung der Leitungsimpedanzen. Dieses aufwändige Verfahren ist mit der Verwendung der erfindungsgemäßen Vorrichtung entbehrlich. Auch Störeinwirkungen werden keine signifikanten Einflüsse haben. Die Messung der Schleifenimpedanz L-PE, welche den Schutzleiter einschließt, kann mit einem kleinen Strom gegenüber der Netzinnenimpedanz L-N gemessen werden, da auf dem PE kein Strom fließen sollte welcher den RCD zum Auslösen bringt. Es stehen hier aktuell Methoden mit 5mA und 15 mA zur Verfügung, welche eine bei 15mA sehr gute und bei 5mA ausreichende Genauigkeit ergeben.

Generell ermöglicht der Einsatz der erfindungsgemäßen Vorrichtungen Prüfintervalle für Elektroprüfungen auszuweiten oder diese durch eine entsprechende Gefährdungsbeurteilung vollständig entbehrlich zu machen. Dies wird für die vorhandene Anlage/Installation, sowie auch für die angeschlossenen elektrischen Verbraucher ermöglicht. Ein übliches Prüfintervall sind 12 Monate für ortsveränderliche Geräte und 48 Monate für Anlagen. Die entsprechenden Prüfnormen sind DIN EN 50699, VDE 0702 für die Wiederholungsprüfung von ortsveränderlichen Arbeitsmitteln und DIN VDE 0105-100 für Anlagen. Die Messkategorie für die erfindungsgemäße Vorrichtung ist bevorzugt CAT II 300V.

Optional ist in der erfindungsgemäßen Vorrichtung ein Relais vorgesehen, um bei entsprechenden Prüf- bzw. Messergebnissen bis zu 16 A einen Stromfluss von der Elektroinstallationsanlage zum elektrischen Verbraucher abzuschalten.

Sofern die Prüfeinrichtung 16 Mittel zum Prüfen und Bestimmen eines Auslösestromes für der RCD (Residual Current Device bzw. Fehlerstrom-Schutzschalter oder umgangssprachlich: FI-Schutzschalter) bzw. zum Prüfen und Bestimmen einer Auslösezeit für den RCD aufweist, sind weitere Funktionalitäten möglich. So sind z.B. nach einer RCD-Prüfung, bei der der RCD auslöst, die Elektroinstallationsanlage und der Verbraucher in einem spannungsfreiem/passivem Zustand. Hier kann dann eine Isomessung durchgeführt werden, bis der RCD bzw. die Netzspannung wieder von Hand eingeschaltet wird.

Beim Prüfen und Bestimmen einer Frequenz eines von der Elektroinstallationsanlage gelieferten Wechselstromes wird mit der Schleifenmessung und Netzinnenimpedanz Messung die Impedanz (komplexer widerstand) ermittelt. Ersatzweise wird ein Ohmscher Widerstand angenommen. Neben dem Schutzleiter wird auch der Widerstand von L und N erfasst. Somit kann nachgewiesen werden dass auch der Leitungsschutzschalter seine Schutzaufgabe erfüllen kann, falls an dem Endstromkreis ein Fehlerfall (z.B ein Kurzschluss) auftritt. Hier muss über den gemessenen Widerstand und der gegebenen Netzspannung ein ausreichender Kurzschlusstrom erreicht werden, welche den RCD auslöst.

## Patentansprüche

1. Vorrichtung (100; 200) zum elektrischen Verbinden eines elektrischen Verbrauchers mit einer Elektroinstallationsanlage, insbesondere einer stationären Elektroinstallationsanlage eines Gebäudes oder einer ortsveränderlichen Elektroinstallationsanlage, beispielsweise einer ortsveränderlichen elektrischen Stromversorgung, wie beispielsweise eines mobilen Stromerzeugungsaggregates, zum bestimmungsgemäßen Betrieb des elektrischen Verbrauchers,
**dadurch gekennzeichnet,**
**dass** die Vorrichtung mindestens eine Prüfeinrichtung (16) aufweist, die für eine Elektroprüfung von sicherheitsrelevanten, elektrischen Eigenschaften des elektrischen Verbrauchers ausgebildet ist.

2. Vorrichtung (100; 200) nach Anspruch 1, **dadurch gekennzeichnet, dass** die Prüfeinrichtung (16) Mittel zur Elektroprüfung des elektrischen Verbrauchers für folgende elektrische Eigenschaften und Schutzeinrichtungen beinhaltet, eine Schutzleiterprüfung, eine Prüfung des Isolationswiderstandes bei elektrischen Verbrauchern mit berührbaren, elektrisch leitfähigen Bauteilen, eine Prüfung des Isolationswiderstandes bei elektrischen Verbrauchern ohne berührbare, elektrisch leitfähige Bauteile, eine Berührstrommessung und/oder eine Schutzleiterstrom- bzw. Differenzstrommessung.

3. Vorrichtung (100; 200) nach Anspruch 1 oder 2, **dadurch gekennzeichnet, dass** die Prüfeinrichtung (16) eine Prüfsonde (18) aufweist, die derart ausgebildet ist, dass diese mit mindestens einem Bauteil des elektrischen Verbrauchers lösbar oder unlösbar verbindbar ist.

4. Vorrichtung (100; 200) nach mindestens einem der vorhergehenden Ansprüche, **dadurch gekennzeichnet, dass** die mindestens eine Prüfeinrichtung für eine Elektroprüfung von sicherheitsrelevanten, elektrischen Eigenschaften der Elektroinstallationsanlage ausgebildet ist.

5. Vorrichtung (100; 200) nach Anspruch 4, **dadurch gekennzeichnet, dass** die Prüfeinrichtung (16) Mittel zur Elektroprüfung der Elektroinstallationsanlage für folgende elektrische Eigenschaften und Schutzeinrichtungen beinhaltet, Prüfen einer Fehlerstrom-Schutzeinrichtung (RCD), Prüfen und Bestimmen eines Auslösestromes für die RCD, Prüfen und Bestimmen einer Auslösezeit für die RCD, Prüfen eines Leitungsschutzschalters (LS), Prüfen und Bestimmen eines ohmschen Widerstandes eines Schutzleiters, Prüfen und Bestimmen einer Frequenz eines von der Elektroinstallationsanlage gelieferten Wechselstromes, Prüfen und Bestimmen einer Phase eines von der Elektroinstallationsanlage gelieferten Wechselstromes, Prüfen und Bestimmen einer Schleifenimpedanz L-N-PE RCD, Prüfen und Bestimmen einer Schleifenimpedanz L-N-PE und/oder Prüfen und Bestimmen einer Netzimpedanz L-N.

6. Vorrichtung nach mindestens einem der vorhergehenden Ansprüche, **dadurch gekennzeichnet, dass** die Vorrichtung ein Elektro-Verlängerungskabel (200), eine Elektro-Mehrfachsteckdose oder eine Steckergehäuse (100) ist.

7. Vorrichtung (100; 200) nach mindestens einem der vorhergehenden Ansprüche, **dadurch gekennzeichnet, dass** die Vorrichtung für eine Elektroinstallationsanlage mit folgenden elektrischen Eigenschaften ausgebildet ist, Netzspannung 0 V bis 300 V Wechselstrom mit 40 Hz bis 60 Hz und Stromstärken bis 16 A.

8. Vorrichtung (100; 200) nach mindestens einem der vorhergehenden Ansprüche, **dadurch gekennzeichnet, dass** die Prüfeinrichtung (16) Mittel zum Detektieren von Fehlerlichtbögen bzw. Schwellichtbögen aufweist.

9. Vorrichtung (100; 200) nach Anspruch 8, **dadurch gekennzeichnet, dass** die Mittel zum Detektieren von Fehlerlichtbögen zum Auswerten eines zeitlichen Differenzstrom-Verlaufes derart ausgebildet sind, dass aus dem zeitlichen Differenzstrom-Verlauf, insbesondere mittels einer Kl, auf einen Fehlerlichtbogen geschlossen wird.

10. Vorrichtung (100; 200) nach Anspruch 8 oder 9, **dadurch gekennzeichnet, dass** die Mittel zum Detektieren von Fehlerlichtbögen zum Auswerten eines oberwelligen ' Verbraucherstromes im Zeitbereich und/oder im Frequenzbereich derart ausgebildet sind, dass aus dem oberwelligen Verbraucherstrom, insbesondere mittels einer KI, auf einen Fehlerlichtbogen geschlossen wird.
